# EUROPÄISCHE PATENTSCHRIFT

(11) **EP 2 512 032 B1**
(45) Veröffentlichungstag und Bekanntmachung des Hinweises auf die Patenterteilung: **01.10.2014**
(21) Anmeldenummer: 12167390.9
(22) Anmeldetag: 24.06.2009
(51) Int. Cl.: H03K 17/96

(54) **Bedieneinrichtung für ein Elektrogerät und Auswerteverfahren für diese Bedieneinrichtung**
Operating device for an electrical device and evaluation method for this operating device
Dispositif de commande pour un appareil électrique et procédé d'évaluation pour ce dispositif de commande

(30) Priorität: 08.07.2008 DE 102008033369
(43) Veröffentlichungstag der Anmeldung: 17.10.2012
(62) Teilanmeldung aus: 09163634.0
(73) Patentinhaber: E.G.O. Elektro-Gerätebau GmbH, 75038 Oberderdingen (DE)
(72) Erfinder: Fluhrer, Henry, 75015 Bretten (DE)
(74) Vertreter: Patentanwälte Ruff, Wilhelm, Beier, Dauster & Partner

(56) Entgegenhaltungen:
- EP-A- 0 512 124
- EP-A- 2 063 533
- DE-A1- 10 359 561
- DE-A1- 19 811 372
- DE-A1-102004 044 355
- DE-B3-102004 024 835
- DE-C1- 10 131 243
- GB-A- 2 426 344
- US-A1- 2008 246 496
- US-B1- 6 310 428

## Beschreibung

### Anwendungsgebiet und Stand der Technik

Die Erfindung betrifft eine Bedieneinrichtung für ein Elektrogerät, wobei die Bedieneinrichtung ein formveränderliches bzw. elastisches BedienFeld aufweist, unter dem mindestens ein Piezo-Sensorelement angeordnet ist.

Aus der DE-A 198 11 372 ist es bekannt, bei einem Kochfeld unter dessen Edelstahl-Rahmen Piezo-Sensorelemente als Bedienelemente anzuordnen. Mit diesen kann erfasst werden, wenn eine Bedienperson einen Finger auf den Bereich oberhalb des Piezo-Sensorelements aufgelegt hat als Bedien-Aktion. Die Anbringung der Piezo-Sensorelemente an der Unterseite des Bedien-Feldes ist aber relativ aufwändig, ebenso deren elektrische Kontaktierung.

Aus der GB-A 2 426 344 ist eine Bedieneinrichtung mit einem Bedienfeld mit Bedienelementen für ein Fahrzeug bekannt, bei der die einzelnen Bedienelemente von ihrer Rückseite her durch Leuchtelemente angeleuchtet bzw. angestrahlt werden können. Die Leuchtelemente sind dabei an einer Rückseite einer unterhalb bzw. hinter den Bedienelementen angeordneten, lichtdurchscheinenden bzw. semi-transluzenten Leiterplatte befestigt und strahlen die Bedienelemente durch die Leiterplatte hindurch an. Zum Erkennen einer Betätigung der Bedieneinrichtung sind Sensoren vorgesehen, die auf einer dem Bedienfeld zugewandten Vorderseite der Leiterplatte angeordnet sind. Die Leiterplatte dient dabei als Trägerplatte sowohl für die Leuchtelemente als auch für die Sensoren, die auf der dem Bedienfeld zugewandten Seite der Leiterplatte angeordnet sind. Die Sensoren sind somit zwischen der Leiterplatte und dem Bedienfeld angeordnet und können ebenfalls von der Lichtstrahlung der Leuchtelemente durchstrahlt werden, so dass noch eine ausreichende Leuchtmenge auf das Bedienfeld trifft. Es ist beschrieben, dass als Sensoren bevorzugt Näherungssensoren verwendet werden, aber auch kapazitive Sensoren oder piezo-elektrische Sensoren geeignet sind.

In der EP-A 0 512 124 ist eine Tastatur offenbart, die eine Mehrzahl von scheibenförmigen Piezo-Elementen aufweist, die hinter einer Abdeckfolie jeweils zwischen zwei Kontaktflächen in Aussparungen einer eine starre Trägerplatte umfassenden Unterlage angeordnet sind. Die Piezo-Elemente sind dabei zwischen der Trägerplatte und der Abdeckfolie angeordnet, also auf einer der Abdeckfolie zugewandten Vorderseite der Trägerplatte. Die Aussparungen für die Piezo-Elemente sind dabei als abgestufte Ausnehmungen einer Trägerplatte ausgebildet. Bei der Trägerplatte handelt es sich um eine starre Leiterplatte, die zugleich zur Aufnahme der auf die Piezo-Elemente ausgeübten Biegekräfte ausgebildet ist, wenn bei einer Betätigung der Bedieneinrichtung die Abdeckfolie im Bereich der Piezo-Elemente mit Druck, vorzugsweise durch eine Fingerkuppe, belastet wird.

Aus der US-B 6,310,428 ist ein piezo-elektrischer Druckschalter bekannt, der bei einer Betätigung ein akustisches Feedbacksignal erzeugt. Dazu weist der Schalter ein piezo-elektrisches Element auf, das an einer Innenseite eines Gehäuses angeordnet ist, wobei ein auf das Gehäuse aufgebrachter Druck, beispielsweise durch einen Bediener, dazu führt, dass von dem piezo-elektrischen Element ein elektrisches Signal erzeugt wird, in Abhängigkeit dessen das akustische Feedbacksignal ausgesendet wird.

Aus der DE-A 103 59 561 ist ebenfalls ein Bedienelement für ein Haushaltsgerät bekannt, das ebenfalls unterhalb eines Bedienfeldes, wie beispielsweise einer Ceranglasplatte eines Kochfeldes angeordnet sein kann. Zum Erkennen einer Betätigung des Bedienfeldes weist das Bedienelement einen berührungsempfindlichen Sensor auf, der wiederum aus einem Sender und zwei Empfängern aufgebaut ist. Es ist beschrieben, dass als berührungsempfindlicher unter anderem auch ein piezoelektrischer Sensor verwendet werden kann.

Die DE-C 101 31 243 offenbart einen kapazitiven Näherungsschalter mit zwei Sensorelektroden, der durch eine spezielle Anordnung der beiden Sensorelektroden zueinander gekennzeichnet ist.

### Aufgabe und Lösung

Der Erfindung liegt die Aufgabe zugrunde, eine eingangs genannte Bedieneinrichtung zu schaffen, mit der Nachteile des Standes der Technik vermieden werden können und insbesondere sowohl Anordnung als auch Anschluss leicht und sicher möglich sind, auch bei einer größeren Anzahl von Piezo-Sensorelementen.

Gelöst wird diese Aufgabe durch eine Bedieneinrichtung mit den Merkmalen des Anspruchs 1. Vorteilhafte sowie bevorzugte Ausgestaltungen der Erfindung sind Gegenstand der weiteren Ansprüche und werden im Folgenden näher erläutert.

Gemäß der Erfindung ist vorgesehen, dass das wenigstens eine Piezo-Sensorelement auf der Rückseite einer Leiterplatte angeordnet ist, insbesondere daran befestigt ist. Die Leiterplatte wird mit der gegenüberliegenden Vorderseite flächig an der Unterseite des Bedien-Feldes angebracht bzw. daran angeordnet und befestigt. Somit wird also das Piezo-Sensorelement nicht direkt an der Unterseite des Bedien-Feldes befestigt, was insbesondere bei einer größeren Anzahl von Piezo-Sensorelementen aufwändig ist, sondern indirekt. Dabei kann vorteilhaft vorgesehen sein, dass das Bedien-Feld Teil eines Rahmens oder einer Frontblende des Elektrogerätes ist bzw. einen Teil davon bildet. Die Befestigung des mindestens einen Piezo-Sensorelementes an der Leiterplatte kann durch herkömmliche, großserientechnisch erprobte Verfahren erfolgen, wie sie gerade bei Bestückung von Leiterplatten bekannt sind. Des weiteren kann dann die Leiterplatte mit dem mindestens einen Piezo-Sensorelement als Baueinheit soweit vorgefertigt werden, dass diese Baueinheit beim Zusammenbau des Elektrogerätes nur noch mit dem Bedien-Feld bzw. Rahmen oder Frontblende eines Elektrogerätes verbunden werden muss bzw. daran befestigt wird. So ist ein präziser Aufbau der Bedieneinrichtung gut möglich mit präziser Funktion, für die hier der mechanische Aufbau wichtig ist.

Vorteilhaft können auf der Leiterplatte mehrere Piezo-Sensorelemente für mehrere Bedienelemente vorgesehen sein. Besonders vorteilhaft sind, möglicherweise bis auf die Ausnahme eines mechanischen Ein-/Ausschalters, alle Bedienelemente der Bedieneinrichtung durch derartige, insbesondere gleichartige, Piezo-Sensorelemente realisiert. Dies vereinfacht den Herstellungsaufwand. Dabei können mehrere Piezo-Sensorelemente bei ausreichend genauer Bedienbarkeit relativ nahe beieinander angeordnet werden. Es ist sogar möglich, ihren Abstand zueinander geringer zu halten als Länge oder Breite eines solchen Piezo-Sensorelementes. So lassen sich auch linienartige Bedien-Elemente bilden, die auch als "Slider" bekannt sind und deren Realisierung mit kapazitiven Sensorelementen beispielsweise aus der DE 102004024835 B3, der DE 102004044355 oder der DE 102005018298 hervorgeht, auf die hier diesbezüglich explizit verwiesen wird.

Ein Piezo-Sensorelement für die Bedieneinrichtung ist erfindungsgemäß scheibenartig bzw. als dünne oder flache Scheibe ausgebildet. Mit einer seiner flachen Seiten ist das Sensorelement dann auf der Leiterplatte befestigt, beispielsweise festgeklebt oder verlötet. Bei der Erfindung weist ein Piezo-Sensorelement eine Piezo-Keramikscheibe auf. Diese Piezo-Keramikscheibe ist mit einer Metallmembran verbunden, insbesondere sind sie miteinander verklebt. Das Piezo-Sensorelement weist sowohl auf seiner Oberseite als auch auf seiner Unterseite einen elektrischen Anschluss auf. Vorteilhaft ist dies ein flächiger Anschluss, was auf beiden Seiten den Anschluss bzw. die elektrische Kontaktierung erleichtert. Grundsätzlich ist ein derartiger Aufbau eines Piezo-Sensorelements bekannt.

Auf der Leiterplatte sind an einer Stelle, an der ein Piezo-Sensorelement sein soll, Kontaktfelder vorgesehen. Diese sind insbesondere als Leiterbahnen auf der Leiterplatte ausgebildet bzw. damit verbunden, wobei davon wegführende Kontaktleitungen ebenfalls als Leiterbahnen vorgesehen sein können. Zur elektrischen Kontaktierung wird also ein Piezo-Sensorelement auf dem Kontaktfeld befestigt, wozu vorteilhaft ein elektrisch leitfähiger Kleber als sogenannter Leitkleber verwendet werden kann, alternativ kann gelötet werden. Ein solches Aufkleben ermöglicht eine sowohl zuverlässige Befestigung als auch eine leichte Herstellung der elektrischen Verbindung.

Eine weitere bzw. die zweite elektrische Kontaktierung hat das Piezo-Sensorelement erfindungsgemäß an der von der Leiterplatte weg weisenden Seite, und diese erfolgt durch einen Kontaktbügel. Ein solcher Kontaktbügel reicht von einem weiteren elektrischen Anschlussfeld samt Anschlussleitung, insbesondere wiederum als Leiterbahn auf der Leiterplatte, auf die freiliegende Seite bzw. Oberseite des Piezo-Sensorelementes. Auch ein Bonding-Verfahren ist eine Möglichkeit, also mit einem Bonding-Draht als Kontaktbügel. Der Kontaktbügel kann auch ein Standard-SMD-Bauelement sein, beispielsweise ein 0-Ohm SMD-Widerstand.

Hier kann vorgesehen sein, dass dieser weitere elektrische Anschluss an der frei liegenden Seite des Piezo-Sensorelementes jeweils ein Anschluss an eine Auswerteeinrichtung ist, der für jedes Piezo-Sensorelement einzeln vorhanden ist. Der andere Anschluss, der direkt über ein Kontaktfeld auf der Leiterplatte an das Sensorelement erfolgt, kann dann ein gemeinsamer Masseanschluss sein. Dies kann selbstverständlich auch andersherum gemacht werden. Der Vorteil eines gemeinsamen Masseanschlusses an die frei liegende Seite der Piezo-Sensorelemente liegt darin, dass hier ein Mehrfach-Kontaktbügel verwendet werden kann. Dieser kann so ausgebildet sein, dass er bei einem oder zwei Befestigungspunkten an der Leiterplatte mehrere Sensorelemente kontaktiert, insbesondere alle. Ein elektrischer Kontakt eines solchen Kontaktbügels an die frei liegende Seite des Piezo-Sensorelementes kann entweder einfach durch Aufdrücken mit Anliegen erfolgen oder durch eine Verklebung mit elektrisch leitfähigem Kleber.

Ein Kontaktbügel oder Mehrfach-Kontaktbügel kann beispielsweise als einfache Metallklammer aus Draht oder einem flachen Blechstreifen ausgebildet sein.

Alternativ zu einer ober- und unterseitigen Kontaktierung des Sensorelements können beide Kontaktierungen auch von einer Seite erfolgen, indem das Piezo-Sensorelement auf der Leiterplatte derart angeordnet ist, daß einerseits eine Anschlußfläche der Piezo-Keramikteils des Piezo-Sensorelements zur Leiterplatte zeigt und direkt mit der Leiterplatte verlötet und/oder verklebt wird. Andererseits wird die ebenfalls zur Leiterplatte hin zeigende überstehende Restringfläche einer Metallmembran, auf die das Piezo-Keramikelement geklebt ist, ebenfalls direkt mit der Leiterplatte verlötet bzw. verklebt und somit elektrisch kontaktiert. Dadurch kann eine oberseitige Kontaktierung entfallen. Als besonderer Vorteil kann dadurch die gesamte Montage und Kontaktierung des Piezo-Sensorelementes in einem Löt- bzw. Klebearbeitsvorgang durchgeführt werden.

Auf der von der Leiterplatte weg weisenden Seite des Piezo-Sensorelements kann zur elektrischen Kontaktierung eine Aufteilung in mehrere elektrisch leitfähige Flächen vorgesehen sein, die jeweils getrennt voneinander angeschlossen sind. So kann ein einzelnes Piezo-Keramikteil funktional in mehrere Sensoren aufgeteilt werden, beispielsweise zwei, drei oder vier Sensoren. Die mehreren elektrisch leitfähigen Flächen können vorteilhaft eine Form aufweisen, die von einer geradlinig geteilten Kreis- oder Rechteckform abweicht. Dabei können solchermaßen gebildete Teil-Flächen ineinander verschlungen sein. So ist eine besonders gute verstärkte Empfindlichkeit in abweichende Richtungen erreichbar.

Grundsätzlich können Piezo-Sensorelemente als Bedien-Elemente an der Bedieneinrichtung frei platziert werden. Vorteilhaft wird mindestens eine Linie von Piezo-Sensorelementen gebildet, insbesondere um ein insgesamt längliches linienartiges Bedienelement nach Art des genannten Sliders zu bilden. Die Reihe von Piezo-Sensorelementen kann in einfacher Ausbildung gerade verlaufen, alternativ auch gekrümmt bzw. bogenartig sein.

In vorteilhafter Weiterbildung der Erfindung können mehrere Piezo-Sensorelemente, insbesondere alle, in mehreren fortlaufenden und parallelen Reihen angeordnet sein. Besonders vorteilhaft sind dies zwei Reihen, wobei insbesondere jeweils Piezo-Sensorelemente sich gegenüberliegend angeordnet sind in den Reihen.

Wie bereits erläutert worden ist, sind vorteilhaft mehrere Piezo-Sensorelemente an der Bedieneinrichtung vorgesehen. In vorteilhafter Ausgestaltung der Erfindung sind sie sämtlich identisch ausgebildet. Sie können eine länglich-rechteckige Form aufweisen mit einer langen Seite und einer kurzen Seite, wobei bei einer vorteilhaften Ausgestaltung der Erfindung ihre langen Seiten nebeneinander liegen. Dies ist in Verbindung mit einem vorbeschriebenen sehr geringen Abstand zwischen den Piezo-Sensorelementen vor allem dazu geeignet, einen vorgenannten Slider zu bilden. Hierfür kann in nochmals weiterer Ausgestaltung der Erfindung vorteilhaft vorgesehen sein, dass die Piezo-Sensorelemente zwar mit ihren langen Seiten benachbart und im Wesentlichen parallel zueinander angeordnet sind. Allerdings sind diese langen Seiten in einem Winkel zwischen 15° und 90° zu einer Linie verdreht, vorzugsweise zwischen 45° bis 60° und 80°, entlang derer die Piezo-Sensorelemente ungefähr angeordnet sind. Wenn zur Bedienung ein Finger mit einer gewissen Fläche über diese Linie durch Auflegen bewegt wird, kann dadurch erreicht werden, dass dieser Finger bzw. seine Position von mindestens einem Piezo-Sensorelement erfasst werden kann, weil er sich darüber befindet. Er kann also sozusagen nicht in der Abstandslücke zwischen zwei Sensorelementen untergehen oder nicht gefunden bzw. festgestellt werden. Die Piezo-Sensorelemente können aber auch wahlweise beliebig und ungeordnet auf der Leiterplatte angeordnet sein.

Bei der Anordnung der Bedieneinrichtung an dem Bedien-Feld kann vorgesehen sein, die Baueinheit aus Leiterplatte und Piezo-Sensorelementen mittels eines doppelseitig klebenden Klebebandes mit ihrer Vorderseite an der Rückseite des Bedien-Feldes festzukleben und zu befestigen. Ein solches doppelseitiges klebendes Klebeband kann nach Art einer Folie ausgebildet sein und sollte eine geringe Dicke aufweisen, vorteilhaft etwa 0,2 mm oder 0,1 mm oder sogar noch weniger. Durch die Dicke des Klebebandes kann ein Ausgleich von Toleranzen erfolgen. Ein solches doppelseitiges Klebeband ermöglicht bei werkseitiger Anbringung an der Bedieneinrichtung eine Vormontage der Befestigung bzw. Verklebung. Die Verklebung kann hier alternativ durch Kleberauftrag mit einem flächig aufgetragenen Klebefilm erfolgen. Eine Verklebung allgemein weist den Vorteil auf, dass eine Tastendruck-sensitive, starre Ankopplung der Leiterplatte an die Bedienblende gewährleistet wird.

Durch die Anordnung der Piezo-Sensorelemente an der Leiterplatte und durch deren Anordnung an der Rückseite des Bedien-Feldes wiederum kann durch Ausnutzung einer wenn auch geringen Durchbiegung des Bedien-Feldes durch Auflegen eines Fingers odgl. darauf und Übertragung dieser Biegung auf das Piezo-Sensorelement auf ein Gegenlager für die Sensorelemente verzichtet werden, wie dies ansonsten für eine solche Bedieneinrichtung notwendig ist. Der Stand der Technik in Form der DE 198 11 372 A1 nämlich benötigt noch derartige Gegenlager, die weiteren Montage- und Bauteilaufwand bedeuten. So kann die von dem Bedien-Feld weg weisende Seite des Sensorelementes im Wesentlichen, vorzugsweise vollständig, frei liegen. Dadurch ist sowohl der Aufbau der Bedieneinrichtung als auch die Anbringung an dem Bedien-Feld vereinfacht.

In weiterer Ausgestaltung der Erfindung kann vorgesehen sein, dass das Bedien-Feld Durchbrüche aufweist, hinter denen Leuchtanzeigen angeordnet sind. Derartige Leuchtanzeigen können mittels LED realisiert sein und vor allem dann die Durchbrüche benötigen, wenn das Bedien-Feld aus Metall oder einem anderen lichtundurchlässigen Material besteht. Derartige Leuchtanzeigen in Form beispielsweise von LED oder Sieben-Segment-Anzeigen können ebenfalls auf der Leiterplatte angeordnet sein, die auch die Piezo-Sensorelemente trägt. Die Erfindung eignet sich besonders gut für Bedien-Felder aus Metall, insbesondere Edelstahl oder Aluminium. Deren Dicke kann etwa einen Millimeter betragen oder weniger, unter Umständen auch etwas mehr. Vorteilhaft ist im Bereich der Piezo-Sensorelemente die Materialdicke gleichbleibend ohne eine Reduzierung, so dass die Herstellung eines solchen Bedien-Feldes aus einem einzigen Metallteil vereinfacht ist. Durch den erfindungsgemäßen Aufbau der Bedieneinrichtung kann auch bei relativ dicken und somit relativ steifen Bedien-Feldern das Auflegen eines Fingers mit nicht allzu großer Kraft, beispielsweise 1 N oder sogar noch deutlich darunter mittels eines Piezo-Sensorelements sowohl allgemein erkannt werden als auch konkret bezüglich des Ort des Auflegens bei mehreren, eng benachbarten Piezo-Sensorelementen unterschieden werden. Es können aber auch große Tastendrücke, beispielsweise deutlich größer als 10 N aufgenommen, beispielsweise werden für vandalensichere Tastaturen.

In weiterer Ausgestaltung der Erfindung weist die Bedieneinrichtung vorteilhaft eine Signalauswertung auf, die auch gleichzeitig eine Ansteuerung für die Sensorelemente sein kann. In Weiterbildung der Erfindung können in der Signalauswertung Differenziermittel vorgesehen sein, die eine Signaldifferenz zwischen zwei benachbarten Piezo-Sensorelementen bilden. Dazu sind die Differenziermittel jeweils mit den Sensorelementen verbunden, wobei ein Ausgang eines solchen Differenziermittels einer weiteren Bearbeitung bzw. Auswertung zugeführt wird. Vorteilhaft kann vorgesehen sein, dass die Bedieneinrichtung mindestens drei Piezo-Sensorelemente aufweist und jeweils zwei direkt benachbarte Piezo-Sensorelenente mit jeweils einem Differenziermittel verbunden sind. So können also das erste und das zweite Sensorelement mit einem ersten Differenziermittel verbunden sein, das zweite und das dritte Sensorelement mit einem zweiten Differenziermittel, usw. Der Ausgang benachbarter Differenziermittel wird dann an eine Signalauswertung gegeben um festzustellen, an welchem Sensorelement bzw. an welcher Stelle die größte Signaländerung stattgefunden hat. Als Differenziermittel können hier vorteilhaft Operationsverstärker vorgesehen sein, die eine nachgeschaltete Signalverstärkung zur sicheren Erkennung aufweisen können. In alternativer Ausgestaltung der Erfindung können die Differenziermittel nicht mit diskreten Bauteilen wie OP-Verstärkern aufgebaut sein, sondern in einem Mikrokontroller, der auch für die Signalauswertung verwendet werden kann. Das Ergebnis einer Impedanzwandlung kann eben dann, wenn keine separaten OP-Verstärker vorgesehen sind, direkt an einen A/D-Wandlereingang eines Mikrokontroller gegeben werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine seitliche Schnittdarstellung durch eine erste Ausbildung einer erfindungsgemäßen Bedieneinrichtung mit Piezo-Sensorelementen auf einer Leiterplatte an der Rückseite einer Blende,
- Fig. 2.: eine Rückansicht der Bedieneinrichtung aus Fig. 1 mit Darstellung des elektrischen Anschlusses der Piezo-Sensorelemente,
- Fig. 3: eine alternative Bedieneinrichtung in vereinfachter Darstellung entsprechend Fig. 2,
- Fig. 4: ein Diagramm des Signalhubs über dem Berührweg bei der Bedieneinrichtung gemäß Fig. 3 bei Bewegen eines Fingers von links nach rechts,
- Fig. 5: eine Abwandlung der Bedieneinrichtung aus Fig. 3 mit zur Längsrichtung schräg gestellten Sensorelementen,
- Fig. 6: das entsprechende Diagramm für den Signalhub über dem Berührweg ähnlich Fig. 4 zu der Bedieneinrichtung gemäß Fig. 5,
- Fig. 7: eine Verschaltung zur Signalauswertung eines Piezo-Sensorelements,
- Fig. 8: eine weitere Verschaltung zur Signalauswertung mehrerer Piezo-Sensorelemente durch das erfindungsgemäße Differenzen-Auswertungsverfahren,
- Fig. 9: eine wiederum alternative Bedieneinrichtung ähnlich Fig. 3,
- Fig. 10: das entsprechende Diagramm für den Signalhub über dem Berührweg ähnlich Fig. 4 zu der Bedieneinrichtung gemäß Fig. 9,
- Fig. 11: eine weitere Abwandlung der Bedieneinrichtung aus Fig. 3 mit zwei Reihen von länglichen Sensorelementen,
- Fig. 12: das entsprechende Diagramm für den Signalhub über dem Berührweg zu der Bedieneinrichtung gemäß Fig. 11,
- Fig. 13: eine vergrößerte Darstellung eines zweigeteilten Sensorelements,
- Fig. 14: eine weitere Abwandlung einer Ausbildung eines Sensorelements mit spezieller Aufteilung der Sensorfläche,
- Fig. 15: eine weitere Abwandlung der Bedieneinrichtung aus Fig. 11 mit Sensorelementen in zwei Reihen als eine Art Feld,
- Fig. 16: das entsprechende Diagramm für den Signalhub über dem Berührweg zu der Bedieneinrichtung gemäß Fig. 15 und
- Fig. 17-19: eine weitere Bedieneinrichtung mit Piezo-Sensorelementen auf einer Leiterplatte an der Rückseite einer Blende in Abwandlung derjenigen aus Fig. 1, die nicht zur beanspruchten Erfindung gehört.

### Detaillierte Beschreibung der Ausführungsbeispiele

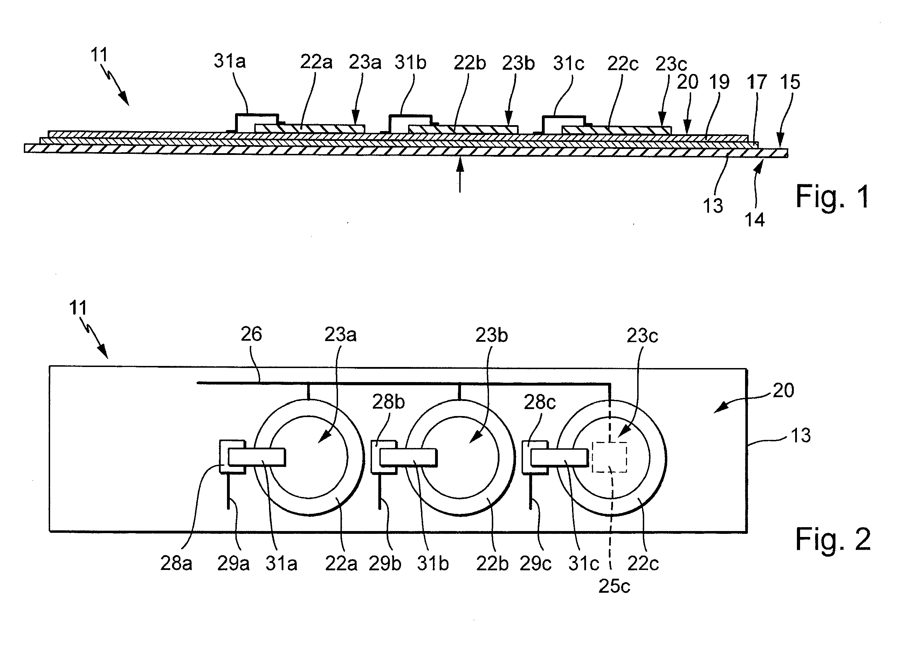

In Fig. 1 ist eine erfindungsgemäße Bedieneinrichtung 11 dargestellt, wie sie beispielsweise für ein vorgenanntes Elektrogerät verwendet werden kann bzw. ein Teil davon sein kann. Die Bedieneinrichtung 11 weist eine Blende 13 auf, beispielsweise als großflächige Blende des Elektrogerätes. Die Blende kann aus Kunststoff oder Metallblech bestehen, beispielsweise aus Edelstahl. Sie weist eine Vorderseite 14 auf, an der mittig eine durch einen Pfeil dargestellte Kraft angelegt ist. Diese Kraft kann von einer Bedienperson durch Auflegen oder Aufdrücken mit einem Finger auf die Vorderseite 14 erzeugt werden.

An einer Rückseite 15 der Blende 13 ist sozusagen die Funktionalität der Bedieneinrichtung 11 vorgesehen. Dazu ist an der Blende 13 mittels eines Klebestreifens 17, der beidseitig klebend ist und auch durch eine Klebeschicht ersetzt sein kann, eine Leiterplatte 19 als Träger für Piezo-Sensorelemente 22 befestigt. Die Piezo-Sensorelemente 22a bis c sind an der Rückseite 20 der Leiterplatte 19 aufgebracht. Sie könnten zwar grundsätzlich auch mit einem Beschichtungsverfahren wie beispielsweise Siebdruck odgl. als Dickschichtbauteile direkt auf die Leiterplatte 19 aufgebracht werden. Vorteilhaft werden sie jedoch als separate Bauteile hergestellt, beispielsweise wie oben beschrieben aus einer Piezo-Keramikscheibe und einer Metallmembran, und anschließend an der Leiterplatte 19 befestigt. Als Befestigung bietet sich dann eine Verklebung an, insbesondere mit einem elektrisch leitfähigen Kleber.

Eine elektrische Kontaktierung an ein Piezo-Sensorelement 22 erfolgt zum einen an seiner Oberseite 23, was nachfolgend näher erläutert wird. Zum anderen erfolgt eine elektrische Kontaktierung an die Unterseite über ein in Fig. 2 in der Draufsicht gestrichelt dargestelltes Kontaktfeld 25c, welches in eine Massekontakt-Leiterbahn 26 auf der Leiterplatte 19 übergeht. Die Kontaktfelder 25 und Massekontakt-Leiterbahn 26 werden als übliche Kupferbahnen auf die Leiterplatte 19 aufgebracht und verbinden den Masseanschluss sämtlicher Piezo-Sensorelemente 22 miteinander. Dann wird auf dieses Kontaktfeld 25, welches in der Größe auch unterschiedlich ausgebildet sein kann, das Piezo-Sensorelement 22 aufgebracht, vorteilhaft aufgeklebt.

Links neben den Piezo-Sensorelementen 22a bis c sind jeweils Kontaktfelder 28a bis c vorgesehen, die jeweils Anschluss-Leiterbahnen 29a bis c aufweisen. Auch diese Kontaktfelder 28 samt Anschluss-Leiterbahnen 29 sind wie die vorbeschriebenen Kontaktfelder 25 samt Leiterbahn 26 auf der Leiterplatte 19 aufgebracht, vorteilhaft als Kupferbahnen. Der elektrische Kontakt von einem Kontaktfeld 28 an die Oberseite 23 des Piezo-Sensorelements 22 erfolgt über Kontaktbügel 31 a bis c. Diese sind U-förmig gebogen, wie aus Fig. 1 zu ersehen ist, und bestehen aus dünnem elastischem Kupferblech. Ein Ende ist auf einem Kontaktfeld 28 befestigt, beispielsweise fest gelötet. Das andere Ende liegt unter Vorspannung an der Oberseite 23 an. Auch hier ist eine feste Verbindung möglich, beispielsweise durch Löten oder mittels Verklebung. Über die Anschluss-Leiterbahnen 29a bis c kann jedes einzelne Piezo-Sensorelement 22 a bis c individuell angesteuert bzw. ausgewertet werden. Die Montage sowohl der Piezo-Sensorelemente 22 als auch der Kontaktbügel 31 kann automatisiert erfolgen mit der Möglichkeit einer schnellen und präzisen Fertigung in großen Mengen.

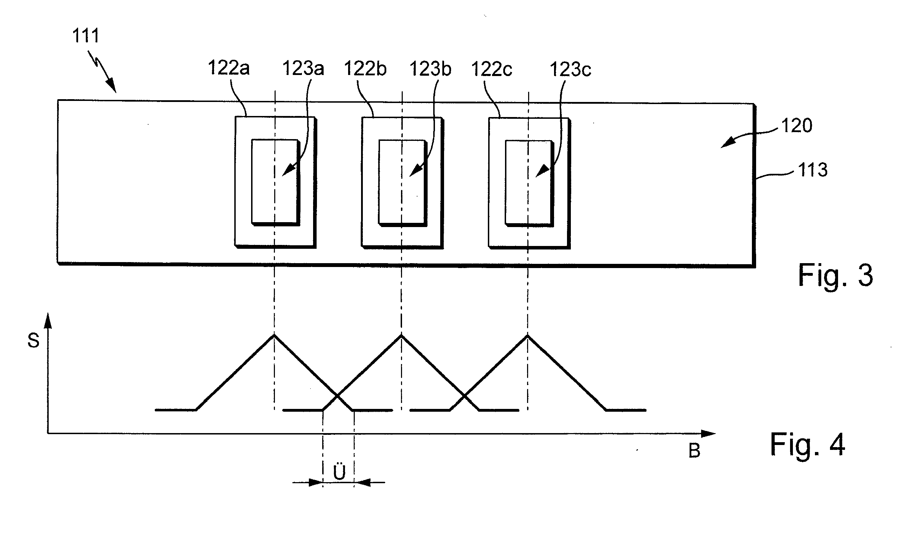

In Fig. 3 ist eine Draufsicht auf eine weitere Bedieneinrichtung 111 dargestellt, die ebenfalls drei Piezo-Sensorelemente 122a bis c aufweist. Deren elektrische Anschlüsse sind der Übersichtlichkeit halber gar nicht dargestellt, sie können jedoch entsprechend derjenigen der Bedieneinrichtung 11 gemäß den Fig. 1 und 2 ausgebildet sein. Des weiteren ist in Abwandlung zu der anderen Bedieneinrichtung hier eine rechteckige Form für die Piezo-Sensorelemente 122 vorgesehen. Insbesondere soll hier die Bedieneinrichtung 111 nicht nur das jeweilige, sozusagen punktförmige Auslösen einer Bedienfunktion durch Aufbringen einer Kraft infolge Auflegen eines Fingers an die Vorderseite der Blende relativ mittig über einem Piezo-Sensorelement erkennen. Es soll auch möglich sein, einen aufgelegten und angedrückten Finger über den Bereich der Piezo-Sensorelemente 122 zu ziehen. Eine solche Bedieneinrichtung wird eben auch Slider genannt und ist beispielsweise vom Grundsatz her aus der DE 102004024835 B3, der DE 102004044355 oder der DE 102005018298 grundsätzlich bekannt. Diese lineare bzw. ziehende Bewegung kann dann mit verschiedenen Bedienfunktionen verknüpft sein, was jedoch für die vorliegende Patentanmeldung keine Rolle spielt. In der vorliegenden Patentanmeldung geht es vielmehr um den konstruktiven Aufbau einer solchen Bedieneinrichtung sowie, gerade im Zusammenhang mit mehreren nebeneinander angeordneten Sensorelementen, um die Realisierung bzw. vor allem auch Auswertung einer solchen Slider-Funktion.

Es ist offensichtlich, dass das Anlegen einer Kraft an der Vorderseite der Blende entsprechend Fig. 1 auch eine Durchbiegung der Blende bewirkt, wenngleich diese sehr gering sein kann, beispielsweise im µm-Bereich. Diese Durchbiegung der Blende bewirkt auch eine Durchbiegung der Leiterplatte und somit auch der Piezo-Sensorelemente, was gut ausgewertet werden kann. Dabei ist aber gerade bei relativ steifen Materialien für die Blende nicht völlig zu vermeiden, dass sich nicht nur über einem einzigen Piezo-Sensorelement, das sozusagen betätigt werden soll, sondern auch über benachbarten Sensorelementen eine Durchbiegung ergibt und somit auch hier ein Signalhub erzeugt wird, wenngleich dieser sehr viel geringer ist. Gerade wenn für eine solche Slider-Funktion wie bei Fig. 3 die Piezo-Sensorelemente 122 relativ nahe beieinander sind, können sich sozusagen die Signale überlappen. Dies ist aus dem Diagramm in Fig. 4 zu ersehen, wo der Signalhub S abhängig von der Stelle am Berührweg B aufgetragen ist. Es ist zu erkennen, dass jeweils an einer strichpunktiert dargestellten Mittelachse eines jeden Piezo-Sensorelements 122 der Signalhub S am größten ist. Links oder rechts davon nimmt mit zunehmender Entfernung der Signalhub S ab. Der hier dargestellte lineare Verlauf ist eine Vereinfachung und muss in der Praxis nicht unbedingt linear sein, gibt aber in etwa die Verhältnisse wieder.

Es ist auch zu erkennen, dass beim Entlangziehen eines Fingers sozusagen der Berührweg B durchlaufen wird. Es gibt immer wieder Bereiche, in denen zwischen den Piezo-Sensorelementen 122 der Signalhub S an beiden Sensorelementen etwa gleich groß ist, also dort, wo sich die beiden dreieckförmigen Kurven schneiden. In diesem Bereich gibt es auch einen sogenannten Überlappungsbereich Ü, in dem an beiden Sensorelementen ein Signal S jeweils relativ klein ist. Durch Vergleich miteinander kann auch hier der exakte Ort der Berührung bzw. der Berührweg B erfasst werden. Dies wird später noch näher erläutert.

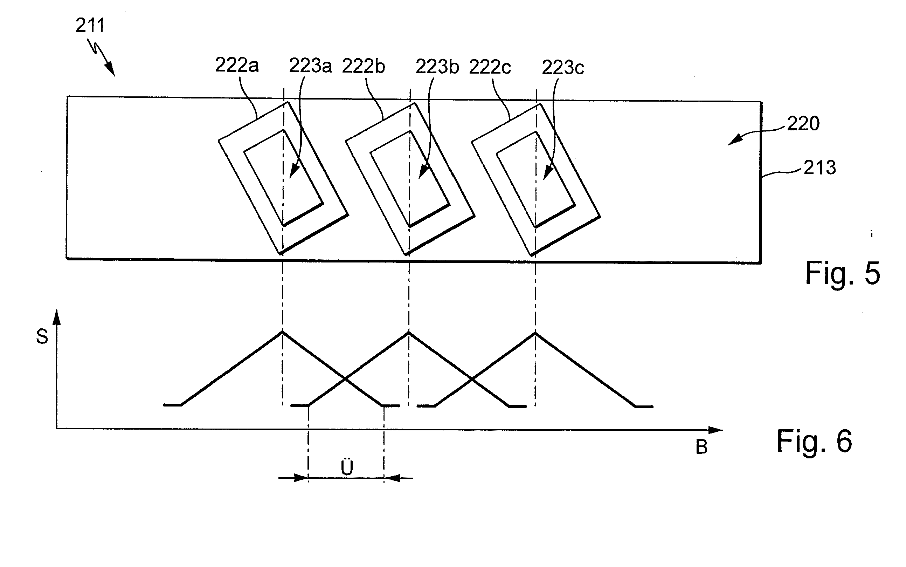

In Fig. 5 ist eine Abwandlung der Fig. 3 mit einer Bedieneinrichtung 211 samt Leiterplatte 213 dargestellt. Im Prinzip ähnlich aufgebaute Piezo-Sensorelemente 222 mit Oberseiten 223 sind dabei im Vergleich zu der Längsachse, entlang derer sich sowohl in Fig. 3 als auch in Fig. 5 die Sensorelemente befinden um etwa 30º verkippt. Da die Durchbiegung der Blende bei Ausübung des Fingerdrucks nicht nur rein punktuell ist, sondern sich über einen gewissen Bereich erstreckt, und dieser Bereich bei Bewegung entlang der Längsrichtung der Anordnung der Piezo-Sensorelement 222 sozusagen ebenfalls eine gewisse Erstreckung senkrecht zu dieser Bewegungsrichtung hat, überlappen sich die Sensorelemente bzw. die an ihnen abgegriffenen Signalhübe S stärker. Dies ist aus dem Diagramm aus Fig. 6 zu ersehen, wo die Überlappung Ü jeweils erheblich breiter ist als in Fig. 4. Dies ist also der eingangs genannte Vorteil der Schrägstellung von länglichen bzw. länglich-rechteckigen Sensorelementen. Die Position eines Fingers mit Druck zwischen den Sensorelementen kann hier nämlich besser erfasst werden, da in dem Zwischenraum zwischen dem Sensorelement, also im Bereich der Überlappung Ü, ein größerer Signalhub S vorliegt.

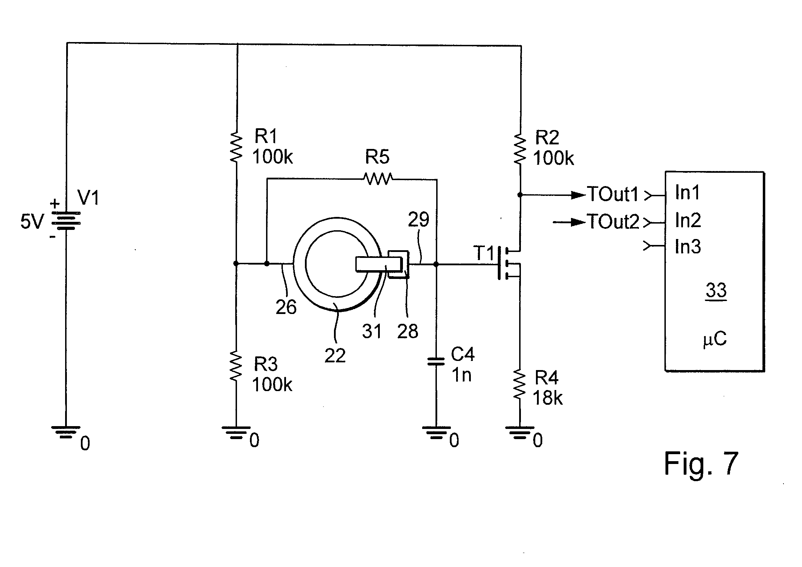

In Fig. 7 ist in dem Schaltdiagramm dargestellt, wie eine Impedanzwandlung bei einem Verfahren zur Signalauswertung eines Piezo-Sensorelements 22 ausgebildet sein kann. Es ist zu erkennen, wie die Massekontakt-Leiterbahn 26 über einen Widerstand R3 gegen Masse geführt ist, während über den Widerstand R1 eine Gleichspannungsquelle V1 damit verbunden ist. Über den Widerstand R5 sind Massekontakte 26 und Anschlüsse 29 verbunden. Des weiteren geht dieser Anschluss an die Basis eines Transistors T1 und ist auch über den Kondensator C1 an Masse gelegt. An dem Transistor T1 liegt über den Widerstand R2 die Versorgungsspannung V1 an, gleichzeitig ist er über einen Widerstand R4 an Masse angeschlossen. Ein Signalausgang T_{Out1} geht von der Schaltung an einen Eingang In₁ einer Steuerung 33, die in einem Mikrocontroller ausgebildet ist. Des weiteren gehen Signalausgänge der anderen Piezo-Sensorelemente 22 genauso an die Steuerung 33, wie durch den Signalausgang T_{Out2} dargestellt ist. Die Funktion dieser Impedanzwandlung ist leicht verständlich.

Da die Signalgewinnung auf dem Piezoeffekt der Piezo-Sensorelemente 22 basiert, werden zwar relativ hohe Signalspannungen, aber sehr kleine Signalströme zurückgeliefert. Für eine elektronische Auswertung ist daher die beschriebene vorherige Impedanzwandlung von Vorteil. Dazu wurde die Transistor-Schaltung gemäß Fig. 7 entwickelt, welche relativ kostengünstig realisiert werden kann. Die Signalausgänge T_{Out} können dann direkt an den A/D-Wandlereingang des Mikrocontrollers 33 geschaltet werden.

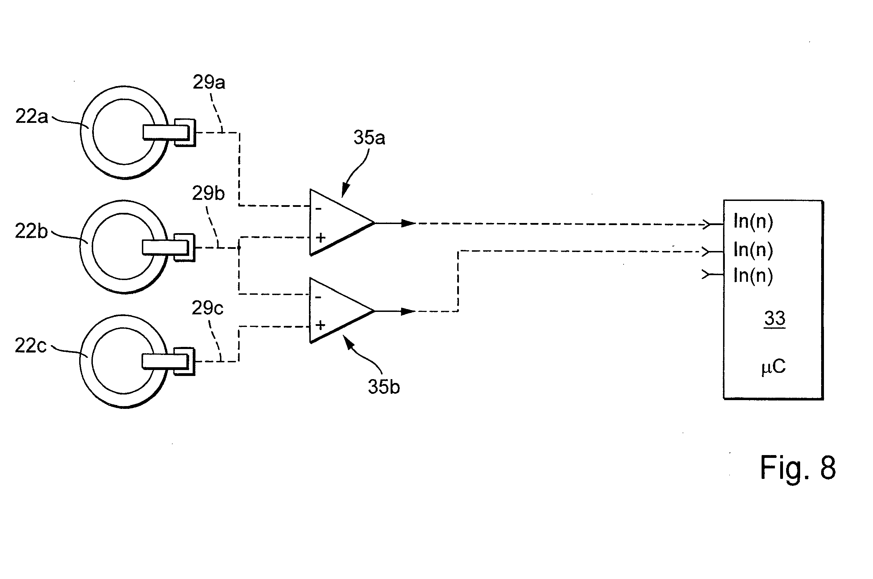

In Fig. 8 ist dargestellt, wie losgelöst von einer Signalaufbereitung an einem einzelnen Piezo-Sensorelement 22 mit einem erfindungsgemäßen Differenzen-Messverfahren Signale ausgewertet werden können. Insbesondere kann so sowohl bei einer punktförmigen Betätigung als auch bei einer vorgenannten Slider-Betätigung die Auswertung verbessert werden.

Dazu ist ein erstes Piezo-Sensorelement 22a über einen Anschluss 29a an den Minus-Eingang eines OP-Verstärkers 35a angeschlossen. Der Anschluss 29b eines zweiten Piezo-Sensorelements 22b ist sowohl an den Plus-Eingang des selben OP-Verstärkers 35a als auch an den Minus-Eingang eines zweiten OP-Verstärkers 35b angeschlossen. Der Anschluss 29c eines dritten Piezo-Sensorelements 22c ist an den Plus-Eingang des OP-Verstärkers 35b angeschlossen. Dies kann für weitere Piezo-Sensorelemente beliebig fortgesetzt werden.

Das Ausgangssignal mit der Differenz der Signale des zweiten Piezo-Sensorelements 22b und des ersten Piezo-Sensorelements 22a bildet den Ausgang des OP-Verstärkers 35a. Beim OP-Verstärker 35b ist es die Differenz zwischen den Signalen des dritten Piezo-Sensorelements 22c und des zweiten Piezo-Sensorelements 22b. Diese Signaldifferenzen gehen an einen Signaleingang In(n) der Steuerung 33 zur Auswertung, an welcher Stelle bzw. an welchem Sensorelement 22 die Betätigung stattgefunden hat.

Ein wesentliches Merkmal für einen einwandfreien und störeinflussunabhängigen Betrieb der Bedieneinrichtung ist eine intelligente Signalaufbereitung. Störeinflüsse können EMV-Einflüsse wie beispielsweise Burst-Beaufschlagung sein. Da die hier beschriebene Bedieneinrichtung auf Piezo-Technologie basiert, handelt es sich sozusagen um eine akustische Einheit, welche auch akustischen Störeinflüssen ausgesetzt ist. Diese sind vielfältig und können Körperschallbeaufschlagung durch Motorbrummen, Klopfen auf das Bedienblech, Luftschall etc. sein.

Um eine Möglichkeit der Kompensation der Störgrößen bzw. Störeinflüsse zu finden, kann eine theoretische Betrachtung über das zeitliche Verhalten der Störbeaufschlagung bzw. des Störgrößeneintrages auf die einzelnen Sensorelemente angestellt werden. Wenn man davon ausgeht, dass die Schallgeschwindigkeit in einem Körper, also beispielsweise bei einem Bedien-Feld aus Metall, ein vielfaches höher ist als die Geschwindigkeit der Bedienung, also des Auflegens eines Fingers, so kann man davon ausgehen, dass die Amplitudenänderung durch Störeinkopplung nahezu gleichphasig an jedem Piezo-Sensorelement anliegt, also die Signaländerung bei allen Sensorelementen sozusagen in der gleichen Richtung stattfindet.

Von diesem Sachverhalt ausgehend, kann ein Verfahren zur Eliminierung der Störeinflüsse angewendet werden, indem man zwischen benachbarten Sensorelementen die beschriebene Signaldifferenz bildet. Bei gleicher Signaländerung durch Störeinflüsse wird die Signalsumme dann gleich Null. Wird aber ein Sensorelement ordnungsgemäß betätigt, so erfährt dieses einen anderen Signalhub als die benachbarten Sensorelemente und die Signaldifferenz wird eindeutig positiv oder negativ, je nach Drücken oder Loslassen des Sensorelements.

Zur Erhöhung der Kompensation der Störeinflüsse kann diese Differenzbildung beliebig auch zwischen mehreren benachbarten Sensorelementen durchgeführt werden. Dabei gilt, dass das gedrückte Sensorelement gegenüber allen anderen Sensorelementen nach Differenzbildung immer ein Maximum bilden muss, siehe Fig. 8.

In einem Versuchsaufbau wurde die Wirkung dieser Art von Kompensation über eine Signaldifferenzbildung mittels Operationsverstärkerschaltung mit nachgeschalteter Signalverstärkung nachgewiesen. Es konnte ein sehr guter Abstand zwischen Nutzsignal und Störsignal, also Signal-Störabstand, erreicht werden. Dadurch konnte einerseits die Bedieneinrichtung sehr druckempfindlich gestaltet werden und andererseits zeigte sich, dass der Einfluss durch Druck auf die benachbarten Sensorelemente aufgrund der Gesamtdurchbiegung der Blende nahezu eliminiert werden konnte.

Bei der späteren Anwendung kann die Störgrößenkompensation durch Differenzbildung sinnvollerweise im Mikrocontroller kostengünstig durchgeführt werden. Als elektronische Beschaltung ist dann lediglich für jedes Sensorelement eine Impendanzwandlung gemäß Fig. 7 erforderlich, welche bereits eine Signalverstärkung beinhaltet.

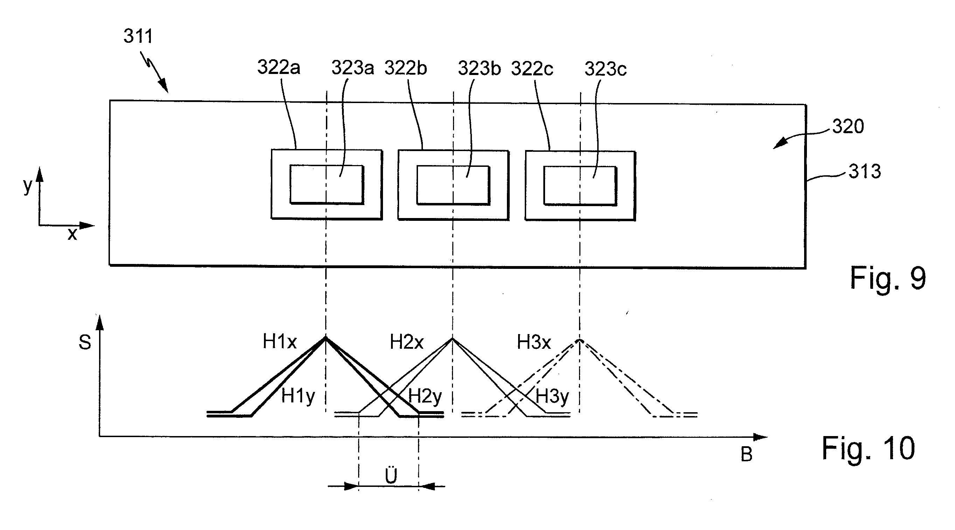

In dem Ausführungsbeispiel gemäß der Fig. 9 ist eine Bedieneinrichtung 311 dargestellt, die grundsätzlich ähnlich ist zu derjenigen aus Fig. 3. Allerdings sind hier die Piezo-Sensorelemente 322a, 322b und 322c mit ihrer Längsrichtung nicht quer zu der Erstreckungsrichtung entsprechend dem Berührweg B, sondern in dessen Längsrichtung ausgerichtet. Sie sind also im Verhältnis zur Fig. 3 um 90° gedreht und weisen einen geringeren Abstand voneinander auf. In dem entsprechenden Diagramm des Signalhubs S über dem Berührweg B gemäß Fig. 10 ist jeweils für die Y-Richtung und für die X-Richtung der Signalhub S dargestellt. Aufgrund der Längserstreckung entlang der Linie der Anordnung der Piezo-Sensorelemente 322 sind die Verläufe der Signalhübe S, wie die oberen eingezeichneten zeigen, breiter bzw. ausgedehnter. Damit kann erreicht werden, dass ein Tastendruck außerhalb der Tastenfläche der Piezo-Sensorelemente 322 in dieser Y-Richtung, die quer ist zum Berührweg B, unempfindlicher wird. Dadurch ist eine Art gerichtete Empfindlichkeit entlang bzw. in Richtung des Berührwegs B möglich.

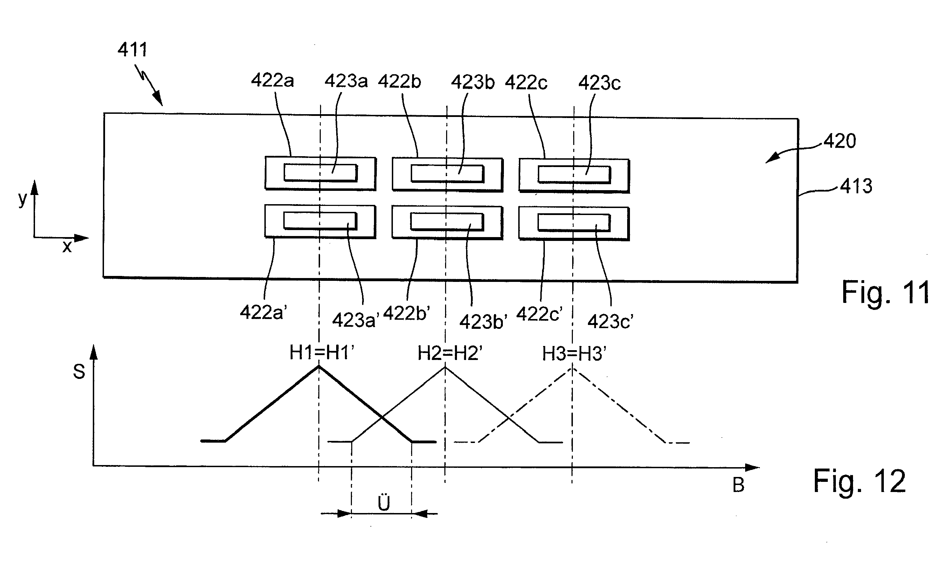

In der nochmals weiteren Bedieneinrichtung 411 gemäß Fig. 11 sind zwei parallele Reihen von Piezo-Sensorelementen vorgesehen, wobei jede dieser Reihen der Anordnung aus Fig. 9 entspricht und nur etwas schmaler ausgebildet ist. In der oberen Reihe verlaufen die Piezo-Sensorelemente 422a, 422b und 422c. In der unteren, parallelen und geringen Abstand aufweisenden Reihe verlaufen die Piezo-Sensorelemente 422a', 422b' und 422c'. Durch diese Anordnung wird eine im Vergleich zu der Fig. 9 nochmals verstärkte gerichtete Empfindlichkeit in X-Richtung, also in Richtung des Berührwegs B, erreicht. Die eingezeichnete Signalüberlappung Ü ist auch einigermaßen groß. Die nochmals verstärkte gerichtete Empfindlichkeit bewirkt, dass ein Tastendruck in der Tastenmitte sehr gut lokalisiert und erkannt werden kann, wenn der Signalhub S des oberen Piezo-Sensorelements und des unteren gleich ist bzw. nahezu gleich ist. Sobald die Signalhübe jedoch deutlicher voneinander differieren, wird das Signal bzw. der Tastendruck verworfen. Dann ist eine Stelle des Berührwegs B tendenziell zu weit in Y-Richtung von der Linie des Berührwegs B abgewichen und entspricht dann nicht mehr einer vorschriftsgemäßen Berührung bzw. Betätigung.

Anstelle der jeweils übereinander angeordneten zwei separaten Piezo-Sensorelementen ist es auch möglich, ein einziges Piezo-Teil zu verwenden und zwei separate Oberseiten bzw. diese allgemein bildenden Elektroden als Signalabgriff anzubringen. Dies entspricht dann rein funktional zwei Piezo-Sensorelementen, lediglich der mechanische bzw. konstruktive Aufwand ist etwas verringert.

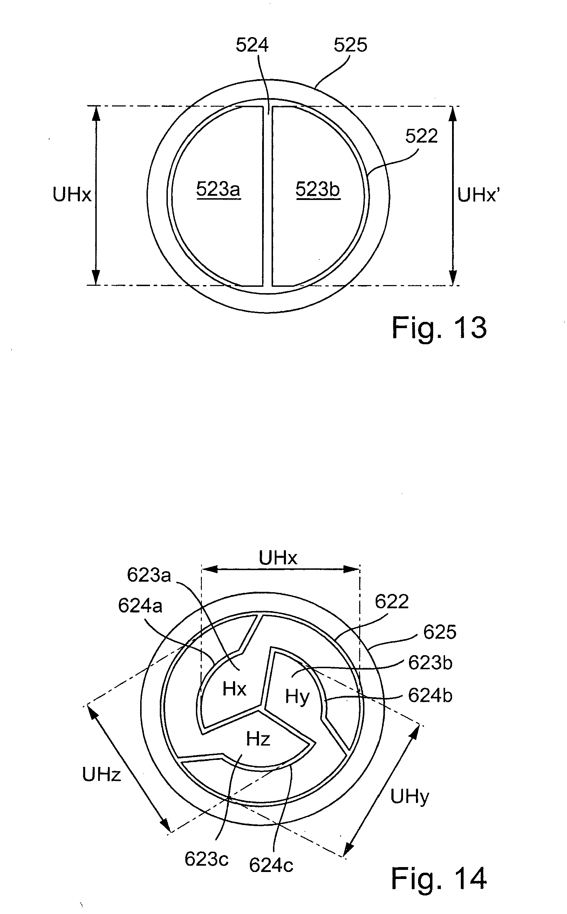

In der Darstellung gemäß Fig. 13 ist ein Beispiel für ein solches quasi funktional zweigeteiltes Piezo-Sensorelement 522 dargestellt. Auf einem Kontaktfeld 525 befindet sich eben das scheibenförmige Piezo-Sensorelement 522 mit etwas kleinerem Durchmesser. Es weist zweigeteilte Oberseiten 523a und 523b auf bzw. entsprechende elektrisch leitfähige Beschichtungen oder Elektroden, an denen dann entsprechend Fig. 1 und 2 jeweils ein hier nicht dargestellter Kontaktbügel angreift. Dadurch wird aus einem Piezo-Sensorelement sozusagen ein zweigeteiltes Element gemacht mit dem Aufwand und den Möglichkeiten einer zweifachen Signalauswertung, allerdings dem konstruktiven Aufwand nur eines einzigen Sensorelements bzw. Piezokeramiksubstrats. Eine Trennlinie 524 zwischen den Oberseiten 523a und 523b bzw. zwischen den diese allgemein bedeckenden Elektroden wäre dann bei einer Anordnung entsprechend Fig. 11 in Richtung des Berührweges B, also in X-Richtung, ausgerichtet. Der Vorteil dieser Ausführung ist vor allem, dass eine sehr genaue Differenzmessung möglich ist, da die Sensoren sozusagen gepaart auf dem gleichen Piezokeramiksubstrat sind. Spannungstoleranzen, die aus unterschiedlicher Scheibendicke, Polarisierung, Verklebung, Umgebungstemperatur odgl. auftreten können, heben sich dabei auf. Bei gleicher Durchbiegung bei Betätigung entlang der Trennlinie 524 entsteht an den beiden Oberseiten 523a und 523b die gleiche Spannung U_{Hx} und U_{Hx'}. Diese Durchbiegung ist dann gleich, wenn ein Tastendruck genau in der Mitte zwischen den beiden Oberseiten 523a und 523b stattfindet, also über der Trennlinie 524. Dies ist optimal für eine liniengetreue Positionserkennung des Tastendrucks in einer Richtung, nämlich in der Richtung der Trennlinie 524.

Es ist leicht vorstellbar, dass anstelle einer Zweiteilung der Oberseite des Piezo-Sensorelements auch eine noch feinere Aufteilung vorgenommen werden kann. Dies kann beispielsweise eine Tetranten- oder Quadrantenaufteilung sein, also in drei oder vier gleich große Kreissegmente.

Eine sozusagen optimierte Variante eines solchen dreigeteilten Piezo-Sensorelements ist in Fig. 14 dargestellt. Hier ist wiederum auf einem metallischen Kontaktfeld 625 ein scheibenförmiges Piezo-Sensorelement 622 angeordnet. Es weist drei Oberseitenbereiche 623a, 623b und 623c auf, die jeweils identisch ausgebildet sind und von Trennlinien 624a bis 624c getrennt werden. Der Verlauf der Oberseiten 623 ist schwer zu beschreiben. Im Wesentlichen ist ihre Ausbildung jedoch derart, dass sie zuerst entgegen dem Uhrzeigersinn nahezu einen Drittel-Umfang des äußeren Randes des Piezo-Sensorelements 622 entlang laufen und dann in der gleichen Drehrichtung nach innen verlaufen in eine Art innere Tetrantenfläche nach Art eines Kreissegments. In gewisser Weise sind die Oberseiten 623 damit sehr kurze Schraubenlinienstücke, die nach innen gezogen sind, mit vergrößertem inneren Ende. Damit lässt sich der effektive Durchmesser und somit auch die Piezospannung U_{H} vergrößern, und zwar jeweils in die in Fig. 14 angegebenen Richtungen. Da die Elektrodenspannung, die am Sensorelement abgenommen werden kann bzw. zwischen Kontaktfeld 625 und Oberseite 623 herrscht, proportional zum Durchmesser des Piezo-Sensorelements 622 ist, ist es von Vorteil, wenn die Segmente der Oberseiten 622 einen möglichst großen effektiven Durchmesser senkrecht zur Biegelinie haben. Bei gleicher Durchbiegung entlang einer solchen Biegelinie entsteht an zwei sich gegenüberliegenden Oberseiten 623, also beispielsweise 623a und 623c, die gleiche Spannung U_{H}. Die Durchbiegung ist dann gleich, wenn der Tastendruck genau in der Mitte zwischen den beiden Elektroden stattfindet. Da dies für jeweils zwei gegenüberliegende Oberseitenpaare ausgewertet werden kann, kann mit dem Aufwand des Aufwertens von drei Spannungen eine positionsgenaue zentrische Positionsortung des Tastendruckes bzw. des Orts der Bedienung und des Auflegens eines Fingers erfolgen. Eine solche Ausbildung ist auch noch entweder mit geringerer oder noch höherer Aufteilung möglich.

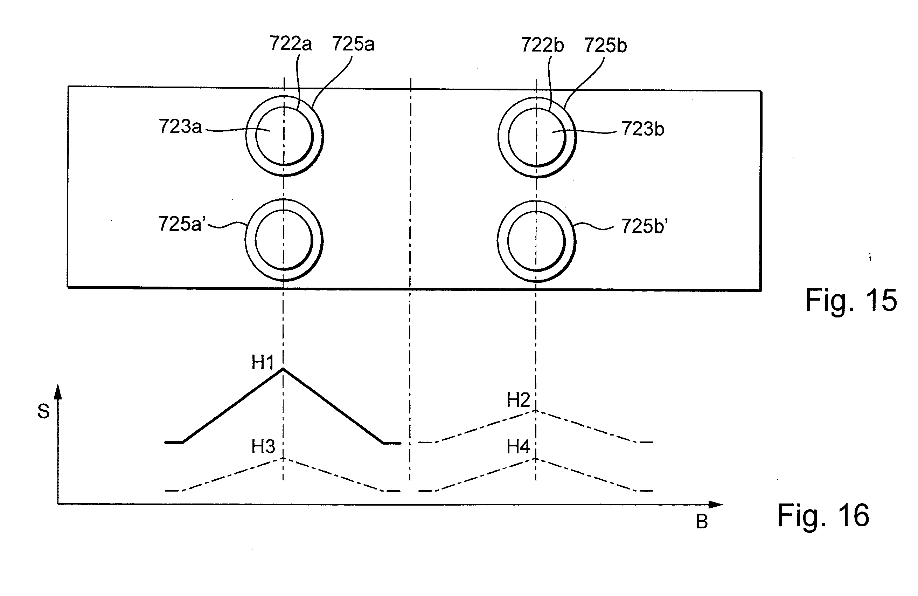

In Fig. 15 ist eine weitere Abwandlung einer Bedieneinrichtung 711 dargestellt. Diese entspricht wieder in etwa derjenigen aus Fig. 11, wobei durch die vier Sensorelemente 722a, 722a' übereinander und 722b, 722b' übereinander eher eine Art flächiges Bedienfeld geschaffen wird.

Es ist gemäß Fig. 16 zu erkennen, wie bei einem eingezeichneten Druckpunkt nahe des Piezo-Sensorelements 722a dessen Signalhub S größer ist als bei den anderen. Hier kann also über das Verhältnis der vier einzelnen Signalpegel bzw. Signalhübe S der einzelnen Piezo-Sensorelemente eine zweidimensionale Lokalisierung erfolgen. Damit kann nicht nur zusätzlich zu einer Bedienung bzw. Betätigung in einer Richtung bzw. entlang einer Linie eine Auswertung erfolgen, sondern auch noch über eine Fläche hinweg. Bei der ersten Möglichkeit kann beispielsweise gegenüber der Bedieneinrichtung 411 gemäß Fig. 11 Aufwand eingespart werden durch Weglassen von Piezo-Sensorelementen. Des weiteren kann noch eine weitere Richtung für eine Bedienung hinzukommen für erweiterte Bedienmöglichkeiten.

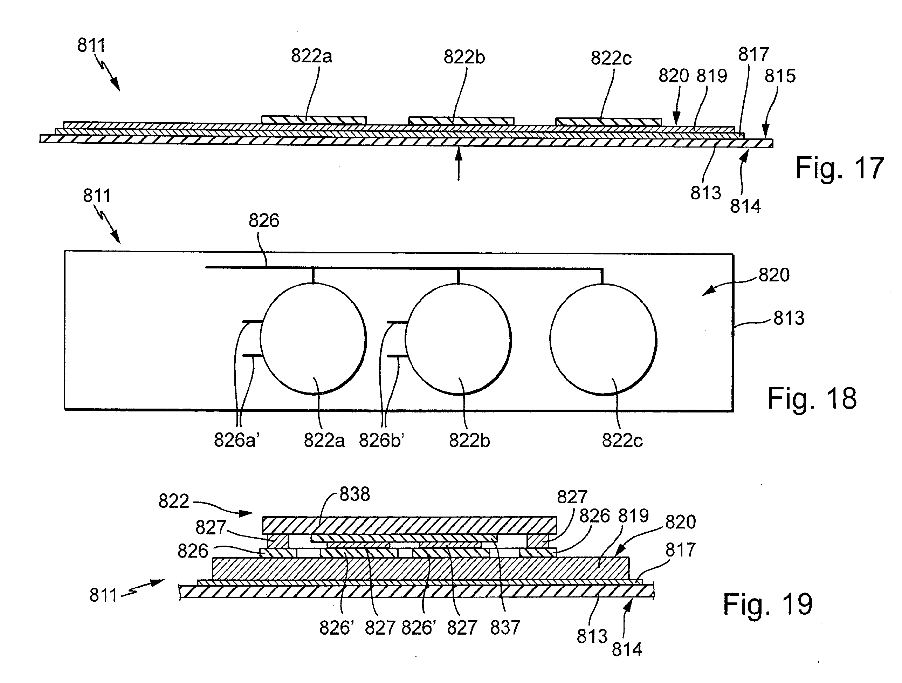

In Fig. 17 ist eine weitere Bedieneinrichtung 811, die nicht zur beanspruchten Erfindung gehört, dargestellt mit einer Blende 813 und einer Vorderseite 814, wie sie im Wesentlichen ähnlich Fig. 1 aufgebaut ist. An einer Rückseite 815 der Blende 813 ist mittels einer Klebeschicht 817 eine Leiterplatte 819 befestigt, die als Träger für Piezo-Sensorelemente 822a, 822b und 822c an ihrer Rückseite 820 ausgebildet ist. In der Draufsicht auf die Bedieneinrichtung 811 gemäß Fig. 18 ist zu erkennen, dass Leiterbahnen 826 bzw. entsprechende Kupferfelder oder Kontaktfelder einerseits und 826a' und 826b' andererseits vorgesehen sind für die einzelnen Piezo-Sensorelemente 822. In der stark vergrößerten Schnittdarstellung gemäß Fig. 19 ist der genaue Aufbau zu erkennen. An die Rückseite 820 der Leiterplatte 819 sind auf den Leiterbahnen 826 und 826' mittels Lötzinn 827, welches alternativ auch ein Leitkleber sein kann, also ein elektrisch leitfähiger Kleber, die Piezo-Sensorelemente 822 befestigt. Dies erfolgt so, dass eine Piezo-Keramikscheibe 837 mittels Lötzinn 827 an den Leiterbahnen 826' mechanisch befestigt und elektrisch daran angeschlossen ist. Zum besseren Verlöten sind die Piezo-Keramikscheiben 837 vorteilhaft mit einer dünnen Metallisierung versehen, beispielsweise einer Silberschicht.

Die Metallmembran 838 des Piezo-Sensorelements 822, welche unlösbar mit der Piezo-Keramikscheibe 837 verbunden ist durch Verkleben odgl., ist in ihrem Außenbereich mit einer Unterseite mittels Lötzinn 827 mit den Leiterbahnen 826 elektrisch verbunden und mechanisch befestigt. Auch hier kann alternativ ein Leitkleber verwendet werden. Die Leiterbahn 826 kann beispielsweise nach Art eines Teilkreises ausgebildet sein und die Leiterbahnen 826' bzw. Kontaktfelder im Wesentlichen umgeben mit einer Unterbrechung, so dass diese gemäß Fig. 18 herausgeführt sein können.

## Patentansprüche

1. Bedieneinrichtung (11, 111, 211, 311, 411) für ein Elektrogerät, mit einem formveränderlichen bzw. elastischen Bedien-Feld (13, 113, 213, 313, 413), insbesondere als Rahmen oder Frontblende des Elektrogerätes, wobei unter dem Bedien-Feld (13, 113, 213, 313, 413) mindestens ein Piezo-Sensorelement (22, 22a-22c, 122a-122c, 222a-222c, 322a-322c, 422a-422c, 422a'-422c', 522, 622, 722a, 722b, 722a', 722b') angeordnet ist, wobei das wenigstens eine Piezo-Sensorelement (22, 22a-22c, 122a-122c, 222a-222c, 322a-322c, 422a-422c, 422a'-422c', 522, 622, 722a, 722b, 722a', 722b') auf der Rückseite (20, 120, 220, 320, 420) einer Leiterplatte (19) angeordnet ist, wobei die Leiterplatte (19) mit der gegenüberliegenden Vorderseite flächig an der Unterseite des Bedien-Feldes (13, 113, 213, 313, 413) angeordnet bzw. daran befestigt ist, **dadurch gekennzeichnet, dass** ein Piezo-Sensorelement (22, 22a-22c, 122a-122c, 222a-222c, 322a-322c, 422a-422c, 422a'-422c', 522, 622, 722a, 722b, 722a', 722b') eine Piezo-Keramikscheibe aufweist, die mit einer Metallmembran verbunden ist, wobei das Piezo-Sensorelement (22, 22a-22c, 122a-122c, 222a-222c, 322a-322c, 422a-422c, 422a'-422c', 522, 622, 722a, 722b, 722a', 722b') sowohl auf seiner Oberseite (23a-23c, 123a-123c, 223a-223c, 323a-323c, 423a-423c, 523a, 523b, 623a-623c, 723a, 723b) als auch auf seiner Unterseite einen elektrischen Anschluss aufweist, wobei eine weitere elektrische Kontaktierung an die von der Leiterplatte (19) weg weisende Seite des Piezo-Sensorelements (22, 22a-22c, 122a-122c, 222a-222c, 322a-322c, 422a-422c, 422a'-422c', 522, 622, 722a, 722b, 722a', 722b') vorgesehen ist durch einen Kontaktbügel (31a-31c), der von einem weiteren elektrischen Anschlussfeld (28a-28c) samt Anschlussleitung (29a-29c) auf der Leiterplatte (19) neben dem Piezo-Sensorelement (22, 22a-22c, 122a-122c, 222a-222c, 322a-322c, 422a-422c, 422a'-422c', 522, 622, 722a, 722b, 722a', 722b') auf dessen frei liegende Seite reicht, wobei der Kontaktbügel (31 a-31c) durch Löten oder Kleben an dem Anschlussfeld (28a-28c) auf der Leiterplatte (19) befestigt ist und gegen das Piezo-Sensorelement (22, 22a-22c, 122a-122c, 222a-222c, 322a-322c, 422a-422c, 422a'-422c', 522, 622, 722a, 722b, 722a', 722b') gedrückt ist.

2. Bedieneinrichtung nach Anspruch 1, **dadurch gekennzeichnet, dass** auf der Leiterplatte (19) mehrere, insbesondere gleichartige, Piezo-Sensorelemente (22, 22a-22c, 122a-122c, 222a-222c, 322a-322c, 422a-422c, 422a'-422c', 522, 622, 722a, 722b, 722a', 722b') angeordnet sind, wobei vorzugsweise ihr Abstand zueinander geringer ist als ihre Breite oder Länge.

3. Bedieneinrichtung nach Anspruch 1 oder 2, **dadurch gekennzeichnet, dass** ein Piezo-Sensorelement (22, 22a-22c, 122a-122c, 222a-222c, 322a-322c, 422a-422c, 422a'-422c', 522, 622, 722a, 722b, 722a', 722b') scheibenartig bzw. als dünne flache Scheibe ausgebildet ist und mit einer flachen Seite auf der Leiterplatte (19) befestigt ist, insbesondere festgeklebt oder verlötet ist.

4. Bedieneinrichtung nach einem der vorhergehenden Ansprüche, **dadurch gekennzeichnet, dass** ein Piezo-Sensorelement (22, 22a-22c, 122a-122c, 222a-222c, 322a-322c, 422a-422c, 422a'-422c', 522, 622, 722a, 722b, 722a', 722b') nur aus einer Piezo-Keramikscheibe besteht mit je einem elektrischen Anschluss auf der Ober-(23a-23c, 123a-123c, 223a-223c, 323a-323c, 423a-423c, 523a, 523b, 623a-623c, 723a, 723b) bzw. Unterseite.

5. Bedieneinrichtung nach Anspruch 1 oder 4, **dadurch gekennzeichnet, dass** auf der Leiterplatte (19) Kontaktfelder (25a-25c, 525, 625, 725a, 725b, 725a', 725b') mit daran angeschlossenen Kontaktleitungen (26)vorgesehen sind und ein Piezo-Sensorelement (22, 22a-22c, 122a-122c, 222a-222c, 322a-322c, 422a-422c, 422a'-422c', 522, 622, 722a, 722b, 722a', 722b') flächig zur elektrischen Kontaktierung an dem Anschlussfeld (25a-25c, 525, 625, 725a, 725b, 725a', 725b') an der Leiterplatte (19) befestigt ist, insbesondere mit einem elektrisch leitfähigen Kleber aufgeklebt oder verlötet ist.

6. Bedieneinrichtung nach einem der vorhergehenden Ansprüche, **dadurch gekennzeichnet, dass** mehrere Piezo-Sensorelemente (22, 22a-22c, 122a-122c, 222a-222c, 322a-322c, 422a-422c, 422a'-422c', 722a, 722b, 722a', 722b'), insbesondere alle, in einer fortlaufenden Reihe angeordnet sind, vorzugsweise zumindest teilweise in einer Geraden.

7. Bedieneinrichtung nach Anspruch 6, **dadurch gekennzeichnet, dass** mehrere Piezo-Sensorelemente (422a-422c, 422a'-422c'), insbesondere alle, in mehreren fortlaufenden und parallelen Reihen angeordnet sind, vorzugsweise zwei Reihen, wobei insbesondere jeweils Piezo-Sensorelemente (422a-422c, 422a'-422c') sich gegenüberliegend angeordnet sind in den Reihen.

8. Bedieneinrichtung nach einem der vorhergehenden Ansprüche, **dadurch gekennzeichnet, dass** mehrere Piezo-Sensorelemente (22a-22c, 122a-122c, 222a-222c, 322a-322c, 422a-422c, 422a'-422c') vorgesehen sind und diese sämtlich identisch ausgebildet sind mit länglich-rechteckiger Form mit einer langen Seite und einer kurzen Seite, wobei vorzugsweise die Piezo-Sensorelemente (22a-22c, 122a-122c, 222a-222c) mit ihren langen Seiten zueinander hin weisend angeordnet sind.

9. Bedieneinrichtung nach Anspruch 8, **dadurch gekennzeichnet, dass** die Piezo-Sensorelemente (222a-222c) mit ihren langen Seiten parallel zueinander angeordnet sind und diese langen Seiten zu einer Linie, entlang derer die Piezo-Sensorelemente (222a-222c) angeordnet sind, um einen Winkel zwischen 15° und 90° verdreht sind, insbesondere zwischen 45° und 80° verdreht sind.

10. Bedieneinrichtung nach einem der vorhergehenden Ansprüche, **dadurch gekennzeichnet, dass** die Leiterplatte (19) mit den Piezo-Sensorelementen (22, 22a-22c, 122a-122c, 222a-222c, 322a-322c, 422a-422c, 422a'-422c', 522, 622, 722a, 722b, 722a', 722b') mittels eines doppelseitig klebenden Klebebandes, insbesondere in Form einer dünnen Folie mit einer Foliendicke von etwa 0,2 mm oder darunter, mit der Vorderseite an der Rückseite (15) des Bedien-Fefdes (13, 113, 213, 313, 413) festgeklebt ist.

11. Bedieneinrichtung nach einem der vorhergehenden Ansprüche, **dadurch gekennzeichnet, dass** sie frei von einem Gegenlager für die Piezo-Sensorelemente (22, 22a-22c, 122a-122c, 222a-222c, 322a-322c, 422a-422c, 422a'-422c', 522, 622, 722a, 722b, 722a', 722b') ausgebildet ist bzw. deren von dem Bedien-Feld (13, 113, 213, 313, 413) weg weisende Seite im wesentlichen frei liegt, vorzugsweise vollständig frei liegt.

12. Bedieneinrichtung nach einem der vorhergehenden Ansprüche, **dadurch gekennzeichnet, dass** das Bedien-Feld (13, 113, 213, 313, 413) aus Metall, insbesondere Edelstahl, mit einer Dicke von etwa 1 mm besteht, wobei es vorzugsweise im Bereich der Piezo-Sensorelemente (22, 22a-22c, 122a-122c, 222a-222c, 322a-322c, 422a-422c, 422a'-422c', 522, 622, 722a, 722b, 722a', 722b') gleich bleibende Dicke aufweist ohne Dickenreduzierung.

13. Bedieneinrichtung nach einem der vorhergehenden Ansprüche, **dadurch gekennzeichnet, dass** die Bedieneinrichtung (11, 111, 211, 311, 411) eine Signalauswertung aufweist und diese eine Impedanzwandlung des von einem Piezo-Sensorelement (22, 22a-22c, 122a-122c, 222a-222c, 322a-322c, 422a-422c, 422a'-422c', 522, 622, 722a, 722b, 722a', 722b') erzeugten Signals aufweist, vorzugsweise mit einer Transistor-Schaltung und einem Anschluss an einen Mikrocontroller (33).

14. Bedieneinrichtung nach Anspruch 13, **dadurch gekennzeichnet, dass** in der Signalauswertung Differenziermittel zur Bildung einer Signaldifferenz zwischen zwei benachbarten Piezo-Sensorelementen (22, 22a-22c, 122a-122c, 222a-222c, 322a-322c, 422a-422c, 422a'-422c', 522, 622, 722a, 722b, 722a', 722b') vorgesehen sind und mit diesen verbunden sind, wobei der Ausgang dieser Differenziermittel einer weiteren Bearbeitung bzw. Auswertung zugeführt ist, wobei insbesondere bei mindestens drei Piezo-Sensorelementen (22, 22a-22c, 122a-122c, 222a-222c, 322a-322c, 422a-422c, 422a'-422c', 522, 622, 722a, 722b, 722a', 722b') jeweils zwei direkt benachbarte Piezo-Sensorelemente (22, 22a-22c, 122a-122c, 222a-222c, 322a-322c, 422a-422c, 422a'-422c', 522, 622, 722a, 722b, 722a', 722b') mit jeweils einem Differenziermittel verbunden sind und der Ausgang benachbarter Differenziermittel einer Signalauswertung zugeführt ist, wobei vorzugsweise die Differenziermittel Operationsverstärker (35a, 35b) aufweisen mit nachgeschalteter Signalverstärkung oder die Differenziermittel in einem Mikrocontroller (33) der Signalauswertung enthalten sind.

## Claims

1. An operating device (11, 111, 211, 311, 411) for an electrical appliance comprising a control panel (13, 113, 213, 313, 413) that is deformable and/or elastic, in particular as frame or front faceplate of the electrical appliance, wherein at least one piezo sensor element (22, 22a-22c, 122a-122c, 222a-222c, 322a-322c, 422a-422c, 422a'-422c', 522, 622, 722a, 722b, 722a', 722b') is arranged under said control panel (13, 113, 213, 313, 413), wherein the at least one piezo sensor element (22, 22a-22c, 122a-122c, 222a-222c, 322a-322c, 422a-422c, 422a'-422c', 522, 622, 722a, 722b, 722a', 722b') is arranged on the rear side (20, 120, 220, 320, 420) of a printed circuit board (19), with the opposing front side of said printed circuit board (19) being arranged and/or fastened in a planar manner to the underside of the control panel (13, 113, 213, 313, 413),
**characterized in that**
a piezo sensor element (22, 22a-22c, 122a-122c, 222a-222c, 322a-322c, 422a-422c, 422a'-422c', 522, 622, 722a, 722b, 722a', 722b') comprises a piezo ceramic disk that is bonded to a metal membrane, wherein the piezo sensor element (22, 22a-22c, 122a-122c, 222a-222c, 322a-322c, 422a-422c, 422a'-422c', 522, 622, 722a, 722b, 722a', 722b') has an electrical connection both on the upper side thereof (23a-23c, 123a-123c, 223a-223c, 323a-323c, 423a-423c, 523a, 523b, 623a-623c, 723a, 723b) and on the underside thereof, wherein a further electrical contact is provided on the side of the piezo sensor element (22, 22a-22c, 122a-122c, 222a-222c, 322a-322c, 422a-422c, 422a'-422c', 522, 622, 722a, 722b, 722a', 722b') facing away from the printed circuit board (19) by means of a contact bow (31a-31c) which extends from a further electrical connecting pad (28a-28c) with connecting line (29a-29c) on the circuit board (19) adjacent to the piezo sensor element (22, 22a-22c, 122a-122c, 222a-222c, 322a-322c, 422a-422c, 422a'-422c', 522, 622, 722a, 722b, 722a', 722b') to the exposed side thereof, wherein the contact bow (31a-31c) is fixed to the connecting pad (28a-28c) on the circuit board (19) by soldering or adhesive bonding and is pressed against the piezo sensor element (22, 22a-22c, 122a-122c, 222a-222c, 322a-322c, 422a-422c, 422a'-422c', 522, 622, 722a, 722b, 722a', 722b').

2. The operating device according to claim 1, **characterized in that** a plurality of, in particular similar, piezo sensor elements (22, 22a-22c, 122a-122c, 222a-222c, 322a-322c, 422a-422c, 422a'-422c', 522, 622, 722a, 722b, 722a', 722b) are arranged on the printed circuit board (19), wherein preferably the distance of said piezo sensor elements from each other is smaller than their width or length.

3. The operating device according to claim 1 or 2, **characterized in that** a piezo sensor element (22, 22a-22c, 122a-122c, 222a-222c, 322a-322c, 422a-422c, 422a'-422c', 522, 622, 722a, 722b, 722a', 722b') is disk-like or is configured as a thin flat disk, and a flat side of said piezo sensor element is fastened to the printed circuit board (19), in particular adhesively bonded or soldered thereto.

4. The operating device according to any one of the preceding claims, **characterized in that** a piezo sensor element (22, 22a-22c, 122a-122c, 222a-222c, 322a-322c, 422a-422c, 422a'-422c', 522, 622, 722a, 722b, 722a', 722b') consists of only one piezo ceramic disk comprising one electrical connection on the upper side (23a-23c, 123a-123c, 223a-223c, 323a-323c, 423a-423c, 523a, 523b, 623a-623c, 723a, 723b) and one on the underside, respectively.

5. The operating device according to claim 1 or 4, **characterized in that** on the circuit board (19) contact pads (25a-25c, 525, 625, 725a, 725b, 725a', 725b') with contact leads (26) connected thereto are provided and a piezo sensor element (22, 22a-22c, 122a-122c, 222a-222c, 322a-322c, 422a-422c, 422a'-422c', 522, 622, 722a, 722b, 722a', 722b') is fixed to the printed circuit board (19) in a planar manner for electrical contact on the contact pad (25a-25c, 525, 625, 725a, 725b, 725a', 725b'), in particular is adhesively bonded or soldered using an electrically conductive adhesive.

6. The operating device according to any one of the preceding claims, **characterized in that** a plurality of piezo sensor elements (22, 22a-22c, 122a-122c, 222a-222c, 322a-322c, 422a-422c, 422a'-422c', 722a, 722b, 722a', 722b'), in particular all of these, are arranged in a continuous row, preferably at least partially in a straight line.

7. The operating device according to claim 6, **characterized in that** a plurality of piezo sensor elements (422a-422c, 422a'-422c'), in particular all of these, are arranged in several continuous and parallel rows, preferably two rows, where in particular piezo sensor elements (422a-422c, 422a'-422c') are respectively arranged opposite each other in the rows.

8. The operating device according to any one of the preceding claims, **characterized in that** a plurality of piezo sensor elements (22a-22c, 122a-122c, 222a-222c, 322a-322c, 422a-422c, 422a'-422c') are provided and all of these are configured identically having an elongated rectangular shape with one long side and one short side, where preferably the long sides of the piezo sensor elements (22a-22c, 122a-122c, 222a-222c) are arranged so as to face each other.

9. The operating device according to claim 8, **characterized in that** the long sides of the piezo sensor elements (222a-222c) are arranged so as to be parallel to each other, and these long sides are rotated relative to a line, along which the piezo sensor elements (222a-222c) are arranged, by an angle between 15° and 90°, in particular by an angle between 45° and 80°.

10. The operating device according to any one of the preceding claims, **characterized in that** the front side of the printed circuit board (19) with the piezo sensor elements (22, 22a-22c, 122a-122c, 222a-222c, 322a-322c, 422a-422c, 422a'-422c', 522, 622, 722a, 722b, 722a', 722b') is adhesively bonded by means of a double-sticky adhesive tape, in particular in the form of a thin film having a film thickness of about 0.2 mm or less, to the rear side (15) of the control panel (13, 113, 213, 313, 413).

11. The operating device according to any one of the preceding claims, **characterized in that** said device is configured free of a counter surface for the piezo sensor elements (22, 22a-22c, 122a-122c, 222a-222c, 322a-322c, 422a-422c, 422a'-422c', 522, 622, 722a, 722b, 722a', 722b') and its side facing away from the control panel (13, 113, 213, 313, 413), respectively, is essentially exposed, preferably completely exposed.

12. The operating device according to any one of the preceding claims, **characterized in that** said control panel (13, 113, 213, 313, 413) is made of metal, in particular stainless steel, having a thickness of approximately 1 mm, preferably said control panel having an unchanging thickness without thickness reduction in the region of the piezo sensor elements (22, 22a-22c, 122a-122c, 222a-222c, 322a-322c, 422a-422c, 422a'-422c', 522, 622, 722a, 722b, 722a', 722b').

13. The operating device according to any one of the preceding claims, **characterized in that** said operating device (11, 111, 211, 311, 411) comprises a signal evaluation that comprises an impedance conversion of the signal generated by a piezo sensor element (22, 22a-22c, 122a-122c, 222a-222c, 322a-322c, 422a-422c, 422a'-422c', 522, 622, 722a, 722b, 722a', 722b'), preferably including a transistor circuit and a connection to a microcontroller (33).

14. The operating device according to claim 13, **characterized in that** in the signal evaluation are provided differentiating means to determine a signal difference between two adjacent piezo sensor elements (22, 22a-22c, 122a-122c, 222a-222c, 322a-322c, 422a-422c, 422a'-422c', 522, 622, 722a, 722b, 722a', 722b'), said differentiating means being connected to said piezo sensor elements, wherein the output of said differentiating means is supplied to further processing and/or evaluation, in which case, in particular with at least three piezo sensor elements (22, 22a-22c, 122a-122c, 222a-222c, 322a-322c, 422a-422c, 422a'-422c', 522, 622, 722a, 722b, 722a', 722b'), two directly adjacent piezo sensor elements (22, 22a-22c, 122a-122c, 222a-222c, 322a-322c, 422a-422c, 422a'-422c', 522, 622, 722a, 722b, 722a', 722b'), respectively, are connected to a respective one of the differentiating means, and the output of adjacent differentiating means is supplied to a signal evaluation, wherein preferably the differentiating means comprise operational amplifiers (35a, 35b) with downstream signal amplification, or the differentiating means are included in a microcontroller (33) of the signal evaluation.

## Revendications

1. Dispositif de commande (11, 111, 211, 311, 411) pour un appareil électrique, avec un panneau de commande (13, 113, 213, 313, 413) déformable et/ou élastique, notamment sous la forme d'un cadre ou d'un cache frontal de l'appareil électrique, au moins un élément de détection piézoélectrique (22, 22a-22c, 122a-122c, 222a-222c, 322a-322c, 422a-422c, 422a'-422c', 522, 622, 722a, 722b, 722a', 722b') étant disposé au-dessous du panneau de commande (13, 113, 213, 313, 413), l'au moins un élément de détection piézoélectrique (22, 22a-22c, 122a-122c, 222a-222c, 322a-322c, 422a-422c, 422a'-422c', 522, 622, 722a, 722b, 722a', 722b') étant disposé sur le côté arrière (20, 120, 220, 320, 420) d'une plaque conductrice (19), la plaque conductrice (19) étant disposée, avec son côté opposé avant, à plat sur le côté inférieur du panneau de commande (13, 113, 213, 313, 413) et/ou y étant fixée, **caractérisé en ce que**
un élément de détection piézoélectrique (22, 22a-22c, 122a-122c, 222a-222c, 322a-322c, 422a-422c, 422a'-422c', 522, 622, 722a, 722b, 722a', 722b') comporte un disque piézocéramique qui est relié à une membrane métallique, l'élément de détection piézoélectrique (22, 22a-22c, 122a-122c, 222a-222c, 322a-322c, 422a-422c, 422a'-422c', 522, 622, 722a, 722b, 722a', 722b') comportant sur son côté supérieur (23a-23c, 123a-123c, 223a-223c, 323a-323c, 423a-423c, 523a, 523b, 623a-623c, 723a, 723b) ainsi que sur son côté inférieur un raccord électrique, une mise en contact électrique supplémentaire étant prévue sur le côté, éloigné de la plaque conductrice (19), de l'élément de détection piézoélectrique (22, 22a-22c, 122a-122c, 222a-222c, 322a-322c, 422a-422c, 422a'-422c', 522, 622, 722a, 722b, 722a', 722b') par le biais d'une bride de contact (31a-31c), qui s'étend d'un panneau de raccord électrique (28a-28c) supplémentaire avec ligne de raccordement (29a-29c) sur la plaque conductrice (19) adjacent au élément de détection piézoélectrique (22, 22a-22c, 122a-122c, 222a-222c, 322a-322c, 422a-422c, 422a'-422c', 522, 622, 722a, 722b, 722a', 722b') au niveau de son surface libre, la bride de contact (31a-31c) étant fixée au panneau de raccord électrique (28a-28c) sur la plaque conductrice (19) par brasage ou collage et étant appuyée contre l'élément de détection piézoélectrique (22, 22a-22c, 122a-122c, 222a-222c, 322a-322c, 422a-422c, 422a'-422c', 522, 622, 722a, 722b, 722a', 722b').

2. Dispositif de commande selon la revendication 1, **caractérisé en ce que** plusieurs éléments de détection piézoélectriques (22, 22a-22c, 122a-122c, 222a-222c, 322a-322c, 422a-422c, 422a'-422c', 522, 622, 722a, 722b, 722a', 722b'), notamment de même type, sont disposés sur la plaque conductrice (19), leur écartement les uns par rapport aux autres étant de préférence davantage réduit que leur largeur ou leur longueur.

3. Dispositif de commande selon la revendication 1 ou 2, **caractérisé en ce qu'**un élément de détection piézoélectrique (22, 22a-22c, 122a-122c, 222a-222c, 322a-322c, 422a-422c, 422a'-422c', 522, 622, 722a, 722b, 722a', 722b') prend une forme de disque et/ou de fin disque plat et est fixé, notamment collé fixement ou brasé, avec un côté plat, sur la plaque conductrice (19).

4. Dispositif de commande selon l'une quelconque des revendications précédentes, **caractérisé en ce qu'**un élément de détection piézoélectrique (22, 22a-22c, 122a-122c, 222a-222c, 322a-322c, 422a-422c, 422a'-422c', 522, 622, 722a, 722b, 722a', 722b') ne se compose que d'un disque piézocéramique avec respectivement un raccord électrique placé sur le côté supérieur (23a-23c, 123a-123c, 223a-223c, 323a-323c, 423a-423c, 523a, 523b, 623a-623c, 723a, 723b) et/ou le côté inférieur.

5. Dispositif de commande selon la revendication 1 ou 4, **caractérisé en ce que** sur la plaque conductrice (19) des panneaux de contact (25a-25c, 525, 625, 725a, 725b, 725a', 725b') dotés des câbles de contact (26) y étant rattachés étant prévus et un élément de détection piézoélectrique (22, 22a-22c, 122a-122c, 222a-222c, 322a-322c, 422a-422c, 422a'-422c', 522, 622, 722a, 722b, 722a', 722b') étant fixé à plat à la plaque conductrice (19) pour réaliser la mise en contact électrique au panneau de contact (25a-25c, 525, 625, 725a, 725b, 725a', 725b'), notamment collé ou brasé au moyen d'une colle électriquement conductrice.

6. Dispositif de commande selon l'une quelconque des revendications précédentes, **caractérisé en ce que** plusieurs éléments de détection piézoélectriques (22, 22a-22c, 122a-122c, 222a-222c, 322a-322c, 422a-422c, 422a'-422c', 722a, 722b, 722a', 722b'), notamment tous ces éléments, sont disposés suivant une ligne continue, de préférence au moins en partie suivant une droite.

7. Dispositif de commande selon la revendication 6, **caractérisé en ce que** plusieurs éléments de détection piézoélectriques (422a-422c, 422a'-422c'), notamment tous ces éléments, sont disposés suivant plusieurs lignes continues et parallèles, de préférence deux lignes, les éléments de détection piézoélectriques (422a-422c, 422a'-422c') étant notamment respectivement disposés en ligne face à face.

8. Dispositif de commande selon l'une quelconque des revendications précédentes, **caractérisé en ce que** plusieurs éléments de détection piézoélectriques (22a-22c, 122a-122c, 222a-222c, 322a-322c, 422a-422c, 422a'-422c') sont prévus et qu'ils sont réalisés de façon entièrement identique en forme de rectangle allongé, avec un côté long et un côté court, les éléments de détection piézoélectriques (22a-22c, 122a-122c, 222a-222c) étant de préférence disposés avec leurs côtés longs orientés les uns vers les autres.

9. Dispositif de commande selon la revendication 8, **caractérisé en ce que** les éléments de détection piézoélectriques (222a-222c) sont disposés parallèlement les uns aux autres avec leurs côtés longs et que ces côtés longs sont pivotés par rapport à une ligne, le long de laquelle les éléments de détection piézoélectriques (222a-222c) sont disposés, selon un angle compris entre 15° et 90°, notamment entre 45° et 80°.

10. Dispositif de commande selon l'une quelconque des revendications précédentes, **caractérisé en ce que** la plaque conductrice (19) est collée fixement aux éléments de détection piézoélectriques (22, 22a-22c, 122a-122c, 222a-222c, 322a-322c, 422a-422c, 422a'-422c', 522, 622, 722a, 722b, 722a', 722b') à l'aide d'une bande de colle biface, notamment sous la forme d'un fin film présentant une épaisseur de film d'environ 0,2 mm ou moins, avec le côté avant collé fixement au côté arrière (15) du panneau de commande (13, 113, 213, 313, 413).

11. Dispositif de commande selon l'une quelconque des revendications précédentes, **caractérisé en ce qu'**il est libre par rapport à un contre-palier pour les éléments de détection piézoélectriques (22, 22a-22c, 122a-122c, 222a-222c, 322a-322c, 422a-422c, 422a'-422c', 522, 622, 722a, 722b, 722a', 722b') et/ou que leur côté écarté du panneau de commande (13, 113, 213, 313, 413) est pour l'essentiel libre, de préférence entièrement libre.

12. Dispositif de commande selon l'une quelconque des revendications précédentes, **caractérisé en ce que** le panneau de commande (13, 113, 213, 313, 413) est en métal, notamment en acier inoxydable, avec une épaisseur d'environ 1 mm, celui-ci comportant de préférence une épaisseur constante dans la zone des éléments de détection piézoélectriques (22, 22a-22c, 122a-122c, 222a-222c, 322a-322c, 422a-422c, 422a'-422c', 522, 622, 722a, 722b, 722a', 722b'), sans réduction d'épaisseur.

13. Dispositif de commande selon l'une quelconque des revendications précédentes, **caractérisé en ce que** le dispositif de commande (11, 111, 211, 311, 411) comporte un système d'analyse de signal et que celui-ci comporte une conversion d'impédance du signal produit par un élément de détection piézoélectrique (22, 22a-22c, 122a-122c, 222a-222c, 322a-322c, 422a-422c, 422a'-422c', 522, 622, 722a, 722b, 722a', 722b'), de préférence avec un circuit de transistor et un raccordement à un microcontrôleur (33).

14. Dispositif de commande selon la revendication 13, **caractérisé en ce que** des moyens de différenciation sont prévus dans le système d'analyse de signal pour la formation d'un signal différentiel entre deux éléments de détection piézoélectriques (22, 22a-22c, 122a-122c, 222a-222c, 322a-322c, 422a-422c, 422a'-422c', 522, 622, 722a, 722b, 722a', 722b') adjacents et que ces moyens sont reliés auxdits éléments, la sortie de ces moyens de différenciation conduisant à un traitement et/ou une analyse supplémentaires, deux éléments de détection piézoélectriques (22, 22a-22c, 122a-122c, 222a-222c, 322a-322c, 422a-422c, 422a'-422c', 522, 622, 722a, 722b, 722a', 722b') directement adjacents étant respectivement reliés à respectivement un moyen de différenciation, notamment en présence d'au moins trois éléments de détection piézoélectriques (22, 22a-22c, 122a-122c, 222a-222c, 322a-322c, 422a-422c, 422a'-422c', 522, 622, 722a, 722b, 722a', 722b'), et la sortie des moyens de différenciation adjacents étant amenée à un système d'analyse de signal, de préférence les moyens de différenciation comportant des amplificateurs opérationnels (35a, 35b) avec un système de renforcement du signal connecté en aval ou les moyens de différenciation étant contenus dans un microcontrôleur (33) du système d'analyse de signal.
